(19) **Europäisches Patentamt**
**European Patent Office**
**Office européen des brevets**

(11) **EP 3 910 347 B1**

(12) **EUROPÄISCHE PATENTSCHRIFT**

(45) Veröffentlichungstag und Bekanntmachung des Hinweises auf die Patenterteilung:
**12.10.2022 Patentblatt 2022/41**

(21) Anmeldenummer: **21173893.5**

(22) Anmeldetag: **14.05.2021**

(51) Internationale Patentklassifikation (IPC):
***G01R 15/20*** *(2006.01)* ***G01R 31/60*** *(2020.01)*

(52) Gemeinsame Patentklassifikation (CPC):
**G01R 15/207;** G01R 31/60

(54) **VERFAHREN ZUM BESTIMMEN ZUMINDEST EINER STROMSTÄRKE UND STROMMESSGERÄT**

METHOD FOR DETERMINING AT LEAST ONE CURRENT INTENSITY AND CURRENT MEASURING DEVICE

PROCÉDÉ DE DÉTERMINATION D'AU MOINS UNE INTENSITÉ DE COURANT ET APPAREIL DE MESURE DE COURANT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.05.2020 DE 102020113301**

(43) Veröffentlichungstag der Anmeldung:
**17.11.2021 Patentblatt 2021/46**

(73) Patentinhaber: **Technische Universität Braunschweig**
**38106 Braunschweig (DE)**

(72) Erfinder:
• **HEINISCH, Philip**
**38110 Braunschweig (DE)**
• **OSTASZEWSKI, Katharina**
**38239 Salzgitter (DE)**

(74) Vertreter: **Gramm, Lins & Partner**
**Patent- und Rechtsanwälte PartGmbB**
**Theodor-Heuss-Straße 1**
**38122 Braunschweig (DE)**

(56) Entgegenhaltungen:
**WO-A1-2018/209436    US-A1- 2014 097 826**
**US-A1- 2014 343 878**

**Beschreibung**

Die Erfindung betrifft ein Verfahren zum Bestimmen zumindest einer Stromstärke in einem Leiter. Gemäß einem zweiten Aspekt betrifft die Erfindung ein Strommessgerät gemäß dem Oberbegriff von Anspruch 1.

Strommessgeräte werden verwendet, um in einem Leiter, beispielsweise einem Kabel, den durch das Kabel fließenden Strom zu bestimmen. Aus dem Stand der Technik ist dazu beispielsweise eine Stromzange bekannt. Diese wird um den stromführenden Leiter herumgelegt und misst das induzierte Magnetfeld. Aus diesem Magnetfeld wird auf den Strom geschlossen, der durch den Leiter fließt. Nachteilig daran ist, dass ein derartiges Strommessgerät nur funktioniert, wenn nur ein Leiter im Kabel Strom führt. Es ist wünschenswert, die Stromstärke auch in Kabeln messen zu können, die zwei oder mehr Leiter aufweisen und/oder in denen unterschiedliche elektrische Ströme fließen.

Es ist aus der WO 2018/209 436 A1 bekannt, auf Basis des Gesetzes von Biot-Savart aus dem Magnetfeld auf die Ströme in einer Mehrzahl an Leitern zu schließen. Dazu muss zumindest die Hälfte des Leiters von den verwendeten Magnetometern umschlossen sein. Das erlaubt es nicht, die Ströme eines in einer Wand liegenden Leiters zu erfassen.

Die US 2018/ 0088 159 A1 beschreibt ein Strommessgerät, in dem ganz allgemein angegeben wird, dass aus dem Magnetfeld, das aus Strömen in einer Mehrzahl an Leitern resultiert, die Ströme berechnet werden können. Dazu werden die Magnetometer in einer Querschnittsebene angeordnet, die senkrecht zur Leiterlängsachse verläuft. Unter der Annahme geradliniger, unendlich ausgedehnter Leiter können so die elektrischen Ströme gemessen werden. Für Flachkabel ist es entbehrlich, die Leiter zu umfassen.

Im Artikel "Overhead High-Voltage Transmission-Line Current Monitoring by Magnetoresistive Sensors and Current Source Reconstruction at Transmission Tower" von Sun et al in IEEE Transactions on Magnetics, Vol. 50, No. 1, Januar 2014 wird beschrieben, dass und in der US 2014 / 0343 878 A1 sind Vorrichtungen beschrieben, mittels derer die Ströme in Freileitungen gemessen werden können. Es müssen die Positionen der einzelnen Leiter der Freileitung bekannten sein. Diese werden beispielsweise durch Vermessen der Positionen mittels eines Lasers bestimmt. Es ist dann ausreichend, einen etwaigen Durchhang der Leiter zu ermitteln. Aufgrund des vergleichsweise großen Abstands der Leiter der Freileitung voneinander können die Magnetfelder der einzelnen Leiter einfach voneinander separiert werden. Das erlaubt einen einfachen Schluss auf die jeweiligen Ströme. Ein solches Verfahren ist für Kabel nicht geeignet, da dessen Leiter relativ zu ihren Leiterdurchmessern so dicht beieinander angeordnet sind, dass sich die Magnetfelder im Fernfeld deutlich überlagern.

Aus der EP 1 830 407 B1 ist bekannt, mehrere Magnetometer auf einer Platine anzuordnen.

Die US 2014/097826 A1 offenbart einen Stromsensor, der einen ersten und einen zweiten Strompfad umfasst. Die Strompfade umfassen jeweils drei Abschnitte, die einen treppenstufenförmigen Verlauf haben. Der zweite und der dritte Abschnitt erstrecken sich daher in x-Richtung von beiden Enden des ersten leitenden Abschnitts aus und sind in y-Richtung benachbart und voneinander getrennt. Zwei magneto-elektrische Umwandlungselemente sind entlang des ersten, zentralen Abschnitts des ersten Strompfads angeordnet und messen ein Magnetfeld eines Stroms in y-Richtung. Die beiden Strompfade verlaufen in x- und z-Richtung zueinander versetzt. Auf diese Weise wird der Einfluss externer Magnetfelder vermindert.

Der Erfindung liegt die Aufgabe zugrunde, Nachteile im Stand der Technik zu vermindern.

Die Erfindung löst das Problem durch ein Strommessgerät mit den Merkmalen von Anspruch 1.

Die Erfindung löst das Problem auch durch ein Verfahren zum Bestimmen zumindest einer Stromstärke in zumindest einem Leiter mit den Schritten (a) Positionieren eines Strommessgeräts, das (i) Q vektorielle Magnetfeldsensoren aufweist mit $Q \geq 5$ und (ii) eine Auswerteeinheit aufweist, relativ zu N Leitern, (b) Erfassen eines Ausrichtungswinkels $\alpha$ zwischen einer Erstreckungsrichtung des Strommessgeräts und einer Leiterlängsachse des Leiters, (c) Erfassen von Magnetfeldkomponenten-Daten von zumindest jeweils zwei Magnetfeldkomponenten mittels der Magnetfeldsensoren und (d) Berechnen der zumindest einen Stromstärke aus den Magnetfeldkomponenten-Daten und dem Ausrichtungswinkel $\alpha$.

Vorteilhaft an der Erfindung ist, dass die Messung von zwei oder mehr Stromstärken in zwei oder mehr Leitern in der Regel möglich ist. Allerdings ist auch die Messung von nur einer Stromstärke erfindungsgemäß.

Vorteilhaft ist zudem, dass die Messung mit einer vergleichsweise geringen Messunsicherheit möglich ist. Das ist insofern überraschend, als dass sich die Magnetfelder, die von den elektrischen Strömen in den Leiter erzeugt werden, überlagern. Die Messergebnisse, die von dem Magnetfeldsensoren erhalten werden, führen daher zu einem mathematischen Gleichungssystem, das häufig unterbestimmt ist. Es wäre also eigentlich zu erwarten gewesen, dass dies eine vergleichsweise hohe Messunsicherheit bedingt oder gar eine Auswertung unmöglich ist. Es hat sich aber herausgestellt, dass dem in der Regel nicht so ist.

Vorteilhaft ist, dass die Stromstärken gemessen werden können, ohne dass das Strommessgerät das Kabel zumindest teilweise umfassen muss.

Wenn an einem Kabel mit verseilten Leitern gemessen wird, ist mit dem erfindungsgemäßen Strommessgerät zudem oft eine geringere Messunsicherheit erreichbar.

In der Regel haben Kabel verseilte Leiter, um das magnetische Fernfeld zu vermindern. Das allerdings erschwert die Strommessung auf Basis genau dieses Fernfelds. Erfindungsgemäß wird die Periodizität der Verseilung ausgenutzt, um eine robuste Messung zu erreichen.

Im Rahmen der vorliegenden Beschreibung wird unter einem vektoriellen Magnetfeldsensor insbesondere ein Bauteil verstanden, mittels dem zumindest zwei, insbesondere drei, Komponenten eines Magnetfelds vermessen werden können. In anderen Worten liefert der Magnetfeldsensor ein Messergebnis, aus dem zumindest auf zwei, vorzugsweise drei, Komponenten des gemessenen Magnetfelds geschlossen werden kann.

Unter der Auswerteeinheit wird insbesondere eine Vorrichtung verstanden, die automatisch, das heißt ohne weiteres Zutun, aus den Magnetfeldkomponenten-Daten, also den Messergebnissen der Magnetfeldsensoren, die zumindest eine Stromstärke im zumindest einen Leiter berechnet.

Es ist möglich, nicht aber notwendig, dass die Auswerteeinheit ein integraler Bestandteil des Strommessgeräts ist. Es ist beispielsweise möglich, dass die Auswerteeinheit in oder an einem Gehäuse befestigt ist, mittelbar fest mit dem Gehäuse verbunden oder von ihm umgeben ist. Alternativ oder zusätzlich ist aber auch möglich, dass die Auswerteeinheit räumlich getrennt von den Magnetfeldsensoren angeordnet ist, beispielsweise außerhalb eines Gehäuses, das die Magnetfeldsensoren umgibt, und insbesondere ohne mechanische Verbindung zwischen den Magnetfeldsensoren und/oder dem etwaig vorhandenen Gehäuse und der Auswerteeinheit.

Es wäre auch möglich, dass die Berechnung beispielsweise auf einem externen Rechner, insbesondere auf einem Smartphone, ausgeführt wird. Die Auswerteinheit kann dann eine Datensammeleinheit aufweisen, die die Daten der Sensoren sammelt und aufbereitet und dann, beispielsweise per Funkverbindung wie insbesondere Bluetooth, an eine Recheneinheit der Auswerteeinheit weitergibt.

Unter dem Merkmal, dass zumindest fünf vektorielle Magnetfeldsensoren vorhanden sind, wird insbesondere verstanden, dass es günstig, nicht aber notwendig ist, dass 6, 7, 8 oder mehr Magnetfeldsensoren vorhanden sind. Je mehr Magnetfeldsensoren vorhanden sind, desto geringer ist in der Regel die Messunsicherheit. Mehr Magnetfeldsensoren führen jedoch auch zu einem komplexeren Aufbau des Strommessgeräts und zu einer aufwändigeren Herstellung. Vorzugsweise ist die Zahl der Magnetfeldsensor daher kleiner als 30.

Unter der Querschnittsebene wird insbesondere eine Ebene verstanden, die senkrecht zu einer Längserstreckungsrichtung des Kabels verläuft, wenn das Strommessgerät entlang des Kabels ausgerichtet ist.

Unter der Längsebene wird insbesondere eine Ebene verstanden, die senkrecht zur Querschnittsebene und entlang der Längserstreckungsrichtung des Kabels verläuft.

Unter der Anlageebene wird insbesondere diejenige Ebene verstanden, die senkrecht zur Querschnittsebene und zur Längsebene verläuft.

Unter dem Schritt des Erfassens des Ausrichtungswinkels wird insbesondere verstanden, dass dieser Ausrichtungswinkel beispielsweise aus einem Speicher der Auswerteeinheit ausgelesen wird. Alternativ oder zusätzlich kann der Ausrichtungswinkel aus einer Eingabevorrichtung ausgelesen werden. In anderen Worten kann ein Bediener des Strommessgeräts den Ausrichtungswinkel mittels der Eingabevorrichtung eingeben. Dieser Ausrichtungswinkel ist in der Regel ohne großen Aufwand mit vergleichsweise geringer Messunsicherheit feststellbar, da die Leiter in dem Kabel in eine leicht feststellbare Richtung verlaufen.

Vorzugsweise beträgt ein Querschnittsebenen-Abstand der ersten Querschnittsebene von der zweiten Querschnittsebene zumindest 10 mm. Günstig ist es, wenn ein Anlageebenen-Abstand der Anlageebenen voneinander zumindest 1 mm beträgt. Vorteilhafterweise beträgt ein Längsebenen-Abstand der Längsebenen voneinander zumindest 4 mm. Die angegebenen Abstände führen jeweils einzeln und insbesondere in Kombination miteinander dazu, dass eine geringe Messunsicherheit erreichbar ist.

Gemäß einer bevorzugten Ausführungsform ist die Auswerteeinheit ausgebildet bekannten verzum automatischen Berechnen der Stromstärken und zumindest eines Verseilungs-Parameter in Form eines Ganghöhen-Parameters (p) und/oder eines Helixradius-Parameters aus den Magnetfeldkomponenten-Daten, Die Stromstärken und der zumindest eine Verseilungs-Parameter werden so berechnet, dass eine Abweichung zwischen den Magnetfeldkomponenten-Daten einerseits und Magnetfeldkomponenten-Werten, die berechnet sind unter Annahme gleicher Querschnitte des Kabels bezüglich der ersten Querschnittsebene und der zweiten Querschnittsebene und für alle Leiter des Kabels jeweils gleicher Stromstärken durch die erste Querschnittsebene und die zweite Querschnittsebene, andererseits minimiert ist.

Diese Minimierung kann beispielsweise durch ein iteratives Verfahren oder mittels des Levenberg-Marquardt-Algorithmus berechnet werden. In anderen Worten werden die Stromstärken und der zumindest eine Verseilungs-Parameter so bestimmt, dass das magnetische Feld, das aus diesen berechnet wird, die gemessenen Magnetfeldkomponenten-Daten optimal beschreibt.

Unter dem Ganghöhen-Parameter wird insbesondere ein Parameter verstanden, aus dem die Ganghöhe einer Helix berechenbar ist. Der Ganghöhe-Parameter kann die Ganghöhe selbst sein oder beispielsweise ein Steigungswinkel der Helix.

Unter dem Helixradius-Parameter wird insbesondere ein Parameter verstanden, aus dem ein Helixradius einer Helix berechenbar ist. Der Helixradius-Parameter kann der Helixradius selbst sein oder beispielsweise ein Durchmesser der Helix.

Das Magnetfeld in kartesischen Koordinaten eines spiralförmig verseilten Leiters lässt sich gemäß folgenden Gleichungen bestimmen:

$$B_{x,m} = \sum_{n=1}^{N} -\frac{\mu_0 I_n}{\pi} a\, \Omega^2 \sum_{g=1}^{\infty} g\, C_g'(ag\Omega) H_g'(\|\vec{r_m} - \vec{r_k}\| g\Omega) * \cos(g(\emptyset_{0,n} - \emptyset_m + \Omega x_m))$$

**Formel 1**

$$B_{y,m} = \sum_{n=1}^{N} -\frac{\mu_0 I_n}{\pi} a\, \Omega^2 * \sin(\emptyset_m) \sum_{g=1}^{\infty} g\, C_g'(ag\Omega) H_g'(\|\vec{r_m} - \vec{r_k}\| g\Omega)$$

$$* \sin(g(\emptyset_{0,n} - \emptyset_m + \Omega x_m)) + \cos(\emptyset_m) * \frac{\mu_0 I_n}{\pi \|\vec{r_m} - \vec{r_k}\|}$$

$$* \left( \frac{1}{2} + a\Omega \sum_{g=1}^{\infty} g\, C_g'(ag\Omega) H_g'(\|\vec{r_m} - \vec{r_k}\| g\Omega) \right.$$

$$\left. * \cos(g(\emptyset_{0,n} - \emptyset_m + \Omega x_m)) \right)$$

**Formel 2**

$$B_{z,m} = \sum_{n=1}^{N} -\frac{\mu_0 I_n}{\pi} a\, \Omega^2 * \cos(\emptyset_m) \sum_{g=1}^{\infty} g\, C_g'(ag\Omega) H_g'(\|\vec{r_m} - \vec{r_k}\| g\Omega)$$

$$* \sin(g(\emptyset_{0,n} - \emptyset_m + \Omega x_m)) - \sin(\emptyset_m) * \frac{\mu_0 I_n}{\pi \|\vec{r_m} - \vec{r_k}\|}$$

$$* \left( \frac{1}{2} + a\Omega \sum_{g=1}^{\infty} g\, C_g'(ag\Omega) H_g'(\|\vec{r_m} - \vec{r_k}\| g\Omega) \right.$$

$$\left. * \cos(g(\emptyset_{0,n} - \emptyset_m + \Omega x_m)) \right)$$

**Formel 3**

Dabei ist $\Omega = 2\pi / p$ mit der Ganghöhe p, $\emptyset_m = \cos^{-1}\left( \frac{z_m - z_k}{\|\vec{r_m} - \vec{r_k}\|} \right)$, a ist der Radius der Helix, $\vec{r_m}$ ist die Position des m-ten Magnetometers mit $\vec{r_m} = (x_m, y_m, z_m)$, $\vec{r_k}$ ist der Mittelpunkt des Kabels mit $\vec{r_k} = (x_k, y_k, z_k)$, um den sich die Leiter winden.

$C_g$ und $H_g$ sind die modifizierten Besselfunktionenen erster und zweiter Gattung und $C_g'$ und $H_g'$ sind ihre Ableitungen im Bezug auf das gesamte Argument.

Ø ist eine Winkelkoordinate in einem Zylinderkoordinatensystem und könnte auch als $\varphi$ geschrieben werden
Die gedrehten Komponenten $B'_{x,m}$, $B'_{y,m}$, $B'_{z,m}$ sind

$$\begin{pmatrix} B'_{x,m} \\ B'_{y,m} \\ B'_{z,m} \end{pmatrix} = \begin{pmatrix} \cos(\gamma) & 0 & \sin(\gamma) \\ 0 & 1 & 0 \\ -\sin(\gamma) & 0 & \cos(\gamma) \end{pmatrix} * \begin{pmatrix} \cos(\alpha) & -\sin(\alpha) & 0 \\ \sin(\alpha) & \cos(\alpha) & 0 \\ 0 & 0 & 1 \end{pmatrix} * \begin{pmatrix} B_{x,m} \\ B_{y,m} \\ B_{z,m} \end{pmatrix}$$

Formel 4

mit dem Ausrichtungswinkel $\alpha$ Neigungswinkel y. Die Komponenten eines Modellvektors $\vec{K}$ sind dann

$$K_{3m} = B'_{x,m} \qquad \text{für k = 3m}$$
$$K_{3m+1} = B'_{y,m} \qquad \text{für k = 3m+1}$$
$$K_{3m+2} = B'_{z,m} \qquad \text{für k = 3m+2}$$

Formel 5

Es hat sich herausgestellt, dass die Stromstärken und der zumindest eine Verseilungs-Parameter numerisch besonders stabil berechnet werden können, wenn zunächst Stromstärke-Schätzwerten der Stromstärken und Position-Schätzwerten der Positionen der Leiter unter der Annahme unverseilter Leiter berechnet werden. Die Annahme unverseilter Leiter ist beispielsweise die Annahme geradliniger, unendlich ausgedehnter Leiter. Danach werden iterativ die Stromstärke-Schätzwerte und der zumindest eine Verseilungs-Parameter verändert, sodass die Abweichung, die oben beschrieben ist, minimiert wird.

Es ist möglich, dass das Strommessgerät nicht vollständig korrekt zum Leiter ausgerichtet wird. Beispielsweise entsteht so ein Ausrichtungswinkel zwischen einer Erstreckungsrichtung des Strommessgeräts und einer Leiterlängsachse des Leiters. Alternativ oder zusätzlich entsteht ein Neigungswinkel zwischen einer Anlagefläche des Strommessgeräts und/oder einer x-Achse des Koordinatensystems des Strommessgeräts einerseits und der Leiterlängsachse des Leiters andererseits. Die Leiterlängsachse ist die Zylinderachse des Hüllzylinders um die Leiter. Der Hüllzylinder ist der Zylinder minimalen Volumens, der die Leiter vollständig umgibt.

Um die Messunsicherheit in diesem Fall zu vermindern, ist die Auswerteeinheit Fotos Weise ausgebildet zum automatischen Berechnen der Stromstärken, zumindest eines Verseilungs-Parameter und zumindest einen Positionierungsparameters in Form eines Ausrichtungswinkels zwischen einer Erstreckungsrichtung des Strommessgeräts und einer Leiterlängsachse des Leiters und/oder eines Neigungswinkels zwischen einer Anlagefläche des Strommessgeräts und einer Leiterlängsachse aus den Magnetfeldkomponenten-Daten. Für diese Stromstärken, den Ganghöhen-Parameter und den zumindest einen Positionierungsparameter gilt, dass eine Abweichung zwischen den Magnetfeldkomponenten-Daten einerseits und Magnetfeldkomponenten-Werten, die berechnet sind unter Annahme gleicher Querschnitte des Kabels bezüglich der ersten Querschnittsebene und der zweiten Querschnittsebene und für alle Leiter des Kabels jeweils gleicher Stromstärken durch die erste Querschnittsebene und die zweite Querschnittsebene, anderseits minimiert ist.

Unter dem Merkmal, dass die Abweichung minimiert ist, wird insbesondere verstanden, dass es sich um ein numerisches Minimum handelt. Dieses numerische Minimum weicht in der Regel vom theoretischen, absoluten Minimum ab.

Vorzugsweise besitzt das Strommessgerät eine Anlagefläche, die eine, vorzugsweise konkave, Leitstruktur aufweist. Die Leitstruktur besitzt eine Leitstruktur-Längsachse und ist so ausgebildet, dass sowohl der Neigungswinkel y als auch der Ausrichtungswinkel $\alpha$ null sind. In diesem Fall verläuft die Leitstruktur-Längsachse vorzugsweise in Richtung einer x-Achse des Geräte-Koordinatensystems des Strommessgeräts. Günstig ist es, wenn die Leitstruktur zumindest zwei, insbesondere zumindest vier, Anlegekanten zum Anlegen an Kabel unterschiedlicher Durchmesser aufweist, sodass das Strommessgerät mittels der Leitstruktur durch Anlegen des Strommessgeräts an das Kabel zum Kabel ausrichtbar ist. Ein Strommessgerät gemäß dem Oberbegriff von Anspruch 1 mit einer solchen Leitstruktur ist ein unabhängiger Gegenstand dieser Anmeldung. In dieser Beschreibung im Zusammenhang mit anderen Aspekten der Erfindung genannte Ausgestaltungen beziehen sich auch für diesen Aspekt der Erfindung.

Ein erfindungsgemäßes Verfahren umfasst vorzugsweise die Schritte, von der Auswerteeinheit bevorzugt ausgeführt werden.

Vorzugsweise werden zumindest 15 Messwerte für Magnetfeldkomponenten aufgenommen. Beispielsweise werden mit 5 Magnetfeldsensoren jeweils 3 Magnetfeldkomponenten gemessen. Gemäß einer bevorzugten Ausführungsform werden von allen Magnetfeldsensoren gemeinsam für jede Raumrichtung bezüglich des Geräte-Koordinatensystems zumindest zwei Magnetfeldkomponenten aufgenommen.

Vorzugsweise erfolgt das Erfassen der Magnetfeldkomponenten-Daten der zumindest jeweils zwei Magnetfeldkomponente mit einer Abtastfrequenz von zumindest 100 Hertz. In anderen Worten werden die Magnetfeldkomponenten-Daten pro Sekunde zumindest einhundertmal erfasst.

Gemäß einer bevorzugten Ausführungsform umfasst das Berechnen der zumindest einen Stromstärke aus den Magnetfeldkomponenten-Daten und dem Ausrichtungswinkel den Schritt Berechnen der zumindest einen Stromstärke aus den Magnetfeldkomponenten-Daten und dem Ausrichtungswinkel ($\alpha$) den Schritt Minimieren des Ausdrucks

$\|\vec{m} - \vec{K}\|^2$ umfasst, wobei $\vec{m} = (B_{x,1}, B_{y,1}, B_{z,1}, B_{x,2}, B_{y,2}, B_{z,2}, ..., B_{x,Q}, B_{y,Q}, B_{z,Q})^t$ mit $\vec{m} \in \mathbb{R}^{3Q}$ ein Messwertvektor

der Magnetfeldkomponenten-Daten ist, mit Q der Anzahl der Magnetfeldsensoren, und $\vec{K} \in \mathbb{R}^{3Q}$ ein Modelldatenvektor ist, für dessen k-te Komponente $K_k$ gilt:

$$
\begin{array}{|c|c|}
\hline
K_{3m} = -\dfrac{\mu_0}{2\pi} \displaystyle\sum_{n=1}^{N} \dfrac{I_n\left(\cos(\beta_{m,n})\sin(\alpha)\cos(\gamma) + \sin(\beta_{m,n})\sin(\gamma)\right)}{\|\vec{r_m} - \vec{r_n}\|} & \text{für k = 3m} \\
\hline
K_{3m+1} = \dfrac{\mu_0}{2\pi}\ \cos(\alpha)\ \displaystyle\sum_{n=1}^{N} \dfrac{I_n\cos(\beta_{m,n})}{\|\vec{r_m} - \vec{r_n}\|} & \text{für k = 3m+1} \\
\hline
K_{3m+2} = \dfrac{\mu_0}{2\pi} \displaystyle\sum_{n=1}^{N} \dfrac{I_n\left(\cos(\beta_{m,n})\sin(\alpha)\sin(\gamma) - \sin(\beta_{m,n})\cos(\gamma)\right)}{\|\vec{r_m} - \vec{r_n}\|} & \text{für k = 3m+2} \\
 & \\
 & \text{Formel (1)} \\
\hline
\end{array}
$$

mit m = 1, .., Q und wobei y ein vorgegebener Neigungswinkel zwischen einer Anlagefläche des Strommessgeräts und einer Leiterlängsachse des Leiters ist. $I_n$ ist die Stromstärke des n-ten Leiters, $\vec{r_n} = (x_n, y_n, z_n)$ die **Position des n-ten Leiters.** $\vec{r_m} = (x_m, y_m, z_m)$ ist die Position des m-ten Magnetometers. $\beta_{m,n}$ ist der Winkel zwischen dem m-ten Magnetometer und dem n-ten Leiter in der y-z-Ebene bezüglich des Koordinatensystems $K_{10}$. $y_m$ ist die y-Koordinate des m-ten Magnetometers, $y_n$ ist die y-Koordinate des n-ten Leiters, $z_m$ ist die z-Koordinate des m-ten Magnetometers im Koordinatensystem $K_{10}$. $z_n$ ist die z-Koordinate des n-ten Leiters. Alle Koordinaten sind die des Koordinatensystems $K_{10}$. Es gilt

$\cos(\beta_{n,m}) = \dfrac{z_m - z_n}{\|\vec{r_m} - \vec{r_n}\|}$ und $\sin(\beta_{n,m}) = \dfrac{y_m - y_n}{\|\vec{r_m} - \vec{r_n}\|}$. Aus diesen Gleichungen lässt sich $\beta_{m,n}$ eindeutig bestimmen. $K_{3m}$ bezeichnet die jeweilige x-Komponente, $K_{3m+1}$ die y-Komponente und $K_{3m+2}$ die z-Komponente des Vektors.

Die oben stehenden Gleichungen ergeben sich aus dem Gesetz von Biot-Savart unter der Annahme eines unendlich ausgedehnten linearen Leiters. Eine derartige Näherung führt in der Praxis in der Regel zu nur geringen systematischen Messunsicherheiten.

Der Neigungswinkel y wird beispielsweise ebenfalls aus dem Speicher der Auswerteeinheit ausgelesen und/oder aus der Eingabevorrichtung ausgelesen. Dieser Ausrichtungswinkel ist in der Regel ohne großen Aufwand mit vergleichsweise geringer Messunsicherheit feststellbar, da die Leiter in dem Kabel in der Regel in Richtung der Erstreckungsrichtung des Stromstärkemessgeräts verlaufen.

Es sei darauf hingewiesen, dass dann, wenn y = 0° oder y = 90° gilt, die trigonometrischen Ausdrücke cosy bzw. sin$\gamma$ 1 oder 0 ergeben und in den Gleichungen oben nicht mehr erscheinen. Selbstverständlich ändert das nicht die Art der Berechnung der Stromstärke. Die Stromstärke ist ein Vektor, dessen Komponenten die Stromkomponenten sind.

Unter dem Merkmal, dass der Ausdruck $\|\vec{m} - \vec{K}\|^2$ minimiert wird, wird insbesondere verstanden, dass eine mathematische Rechnung durchgeführt wird, die ein Ergebnis liefert, dass diesen Ausdruck minimiert. Es ist möglich, nicht aber notwendig, dass explizit die angegebenen Gleichungen verwendet werden. Es ist auch möglich, dass andere Gleichungen verwendet werden, die den gleichen mathematischen Gehalt haben. Beispielsweise ist es möglich, statt in kartesischen Koordinaten in einem anderen Koordinatensystem zu rechnen, beispielsweise in Kugelkoordinaten, Zylinderkoordinaten oder einem anderen, beliebig gewählten Koordinatensystem. In diesem Fall ergeben sich selbstverständlich andere Terme, die Gleichungen bleiben jedoch die gleichen.

Es ist möglich, dass in der verwendeten Gleichung der Neigungswinkel y nicht erscheint, sondern dass stattdessen dafür ein fixer Zahlenwert verwendet wird. Dieser Zahlenwert kann beispielsweise 0°, 90° oder ein sonstiges vielfaches von 90° sein.

Es ist zudem möglich, dass die Auswerteeinheit einen frei programmierbaren Prozessor aufweist, auf dem ein Programm läuft, das die angegebene Berechnung durchführt. Beispielsweise wird ein FPGA (field programmable gate array) verwendet, das heißt, dass das Programm, dass die oben beschriebene Berechnung durchführt, in die Auswerteeinheit eingeladen ist. Alternativ ist es auch möglich, dass die Berechnung von einer fest einprogrammierten Schaltung durchgeführt wird. Eine derartige Schaltung wird beispielsweise als ASIC (application-specific integrated circuit) bezeichnet.

Günstig ist es, wenn der Neigungswinkel y von einer Eingabevorrichtung ausgelesen wird. Der Neigungswinkel ist in der Regel mit vergleichsweise einfachen Mitteln feststellbar. Wird beispielsweise das Strommessgerät mit seiner Anlagefläche auf ein Kabel aufgesetzt, so ist der Neigungswinkel y in sehr guter Näherung 0°.

Es ist günstig, wenn das Strommessgerät, insbesondere die Lage der Anlagefläche, so ausgebildet ist, dass ein Auflegen des Strommessgeräts mit seiner Anlagefläche auf das Kabel dazu führt, dass der Neigungswinkel y kaum, insbesondere höchstens um 3°, von $\gamma = 0°$ abweicht.

Vorzugsweise umfasst das Verfahren die Schritte (i) Erfassen der Anzahl N an Leitern, insbesondere von einer Eingabevorrichtung und (ii) Berechnen der Stromstärken für N Leiter. In der Regel ist bekannt, wie viele Leiter sich in der Nähe des Strommessgeräts befinden. Sollen beispielsweise die Stromstärken in einem Kabel mit N = 3 Leitern bestimmt werden, so kann vom Benutzer die Zahl N = 3 eingegeben werden. Dazu besitzt das Strommessgerät vorzugsweise eine Eingabevorrichtung.

Günstig ist es, wenn das Verfahren die Schritte (i) Berechnen der Stromstärken für N Leiter und für (N+1) Leiter, sodass Mehrleiter-Stromstärken erhalten werden, und (ii) Bestimmen der einer Minimum-Stromstärke in Form der kleinsten der (N+1) Mehrleiter-Stromstärken ($I_{n+1}$) und (iii) Ausgeben der Stromstärken für N Leiter, wenn die Minimum-Stromstärke kleiner ist als ein vorgegebener Mindest-Stromstärkewert, aufweist.

Es ist denkbar, dass der Benutzer eine zu kleine Zahl N an Leitern angibt. Um zu vermeiden, dass dadurch ein fehlerhaftes Messergebnis entsteht, wird die gleiche Rechnung für N + 1 Leiter durchgeführt. War die Zahl N nicht zu klein, insbesondere die korrekte Anzahl an Leitern, so ergibt das Bestimmen der Stromstärken für den (N + 1)-ten Leiter eine sehr kleine Minimum-Stromstärke. In diesem Fall werden die Stromstärken für N Leiter ausgegeben.

Unterschreitet bei der Berechnung für (N+1) Leiter die Minimum-Stromstärke den Mindest-Stromstärkewert, so ist dies ein Hinweis darauf, dass N für die Zahl der Leiter nicht korrekt ist und vom Benutzer falsch angegeben wurde. In diesem Fall wurde eine Fehlermeldung ausgegeben. Unter einer Fehlermeldung wird eine Nachricht verstanden, die die Tatsache kodiert, dass die angegebene Zahl N an Leitern nicht korrekt ist. Das kann auch dadurch geschehen, dass für mehr als N Leiter die jeweiligen Stromstärken ausgegeben werden.

Günstig ist es, wenn das Verfahren die folgenden Schritte aufweist: (a) Bestimmen einer Minimum-Stromstärke in Form einer kleinsten Stromstärke für N Leiter, (b) wenn die Minimum-Stromstärke kleiner ist als ein vorgegebener Mindest-Stromstärkewert, (i) Bestimmen einer Minimum-Stromstärke in Form einer kleinsten Stromstärke quer zur Erstreckungsrichtung des Strommessgeräts für (N-1) Leiter, (ii) wenn die Minimum-Stromstärke für (N-1) Leiter kleiner ist als der vorgegebener Mindest-Stromstärkewert, Wiederholen von Schritt (i) für jeweils einen Leiter weniger, bis die Minimum-Stromstärke zumindest dem Mindest-Stromstärkewert entspricht. Vorzugsweise hat das Verfahren dann den Schritt (iii) des Ausgebens einer Meldung, die die Zahl der Leiter kodiert, für die gilt, dass die Berechnung zu dieser Zahl der Leiter die Minimum-Stromstärke zumindest dem Mindest-Stromstärkewert entspricht.

In anderen Worten wird so lange die Zahl N der Leiter vermindert, bis für alle Leiter der vorgegebene Mindest-Stromstärkewert überschritten wird. Ist die Minimum-Stromstärke für N-1 Leiter nicht kleiner als der vorgegebene Mindest-Stromstärkewert, so werden keine zusätzlichen Schritte durchgeführt. So ist sichergestellt, dass die kleinstmögliche Anzahl an Leitern angenommen wird. Es wird so in der Regel eine geringere Messunsicherheit erreicht.

Wird das Strommessgerät so angeordnet, dass seine Erstreckungsrichtung der Leiterlängsachse entspricht, so wird bei konstantem Strom durch die Leiter der größtmögliche Strom, also ein Strom, der größer ist als die Ströme, die für alle anderen Ausrichtungen des Strommessgeräts gemessen werden. Dies kann als Definition der Erstreckungsrichtung verwendet werden.

Ein erfindungsgemäßes Strommessgerät besitzt vorzugsweise eine Auswerteeinheit, die zum automatischen Durchführen eines oben beschriebenen Verfahrens ausgebildet ist. Hierunter wird insbesondere verstanden, dass die Auswerteeinheit ohne weiteres Eingreifen eines Benutzers aus den Messdaten der Magnetfeldsensoren die Stromstärken berechnet und bevorzugt jeweils zwei, insbesondere alle drei, Komponenten der Stromstärken durch die Leiter berechnet.

Günstig ist es, wenn die Magnetfeldsensoren Dünnschicht-Sensoren sind, die unter Einfluss eines magnetischen Flusses bzw. eines magnetischen Feldes ihren elektrischen Widerstand ändern. Beispielsweise ist zumindest ein Magnetfeldsensor ein GMR (giant magnetoresistance)-Sensor. Alternativ oder zusätzlich ist zumindest ein Magnetfeldsensor ein AMR (anisotroper magnetoresistiver Effekt)-Sensor. Wieder alternativ oder zusätzlich ist zumindest ein Magnetfeldsensor ein TMR (magnetischer Tunnelwiderstand)-Sensor. Wieder alternativ oder zusätzlich ist zumindest einer der Magnetfeldsensoren GMR (giant magnetoresistance)-Sensor. Diese Sensoren sind vergleichsweise einfach herzustellen und besitzen dennoch eine geringe Messunsicherheit.

Günstig ist es, wenn zumindest zwei der Dünnschicht-Sensoren auf einer gemeinsamen Platine angeordnet sind. Alternativ oder zusätzlich können zumindest zwei der Dünnschicht-Sensoren auf einem gemeinsamen Chip angeordnet sein. Auf diese Wiese sind die Positionen der Dünnschicht-Sensoren relativ zueinander mit hoher Genauigkeit bekannt. Zudem wird eine Änderung der Position der Dünnschicht-Sensoren relativ zueinander verhindert.

Günstig ist es, wenn zumindest zwei der Dünnschicht-Sensoren auf zwei unterschiedlichen Platinen, die miteinander starr, insbesondere stoffschlüssig verbunden sind, angeordnet sind. Alternativ oder zusätzlich sind zumindest zwei der Dünnschicht-Sensoren auf zwei unterschiedlichen Chips, die miteinander starr, insbesondere stoffschlüssig, verbunden sind, angeordnet. Auf diese Weise können die Dünnschicht-Sensoren in einer weiteren Raumdimension voneinander beabstandet angeordnet werden. Das führt zu Messergebnissen bezüglich der Stromstärke mit einer besonders geringen Messunsicherheit.

Vorzugsweise sind die Magnetfeldsensoren voneinander um jeweils einen Magnetfeldsensor-Abstand beabstandet. Dieser Magnetfeldsensor-Abstand beträgt vorzugsweise zumindest 2 mm und/oder höchstens 100 mm. Auf diese Weise können typische Ströme von mehr als 10 Milliampere mit einer hinreichend kleinen Messunsicherheit gemessen werden. Es ist möglich, nicht aber notwendig, dass die Magnetfeldsensor-Abstände gleich sind. Insbesondere ist es auch möglich, dass sich zumindest zwei Magnetfeldsensor-Abstände voneinander unterscheiden.

Günstig ist es, wenn das Strommessgerät als Handgerät ausgebildet ist. Hierunter wird insbesondere verstanden, dass das Strommessgerät eine Masse von höchstens 3 Kilogramm, insbesondere 1 Kilogramm, vorzugsweise höchstens 300 Gramm hat. Zudem besitzt das Strommessgerät vorzugsweise eine Anlagefläche, dessen Abmessungen höchstens 20 cm bis 30 cm betragen. Auf diese Weise kann das Strommessgerät einfach mobil eingesetzt werden und eignet sich beispielsweise für die Verwendung auf Baustellen.

Im Folgenden wird die Erfindung anhand der beigefügten Zeichnungen näher erläutert. Dabei zeigt

Figur 1    in Figur 1a ein erfindungsgemäßes Strommessgerät in einer perspektivischen Ansicht, das auf einem Kabel angeordnet ist, in Figur 1b eine schematische Ansicht von oben und in Figur 1c eine schematische Schnittansicht von der Seite, und

Figur 2    zeigt eine Detailansicht des Strommessgeräts, bei dem das Gehäuse entfernt wurde.

Figur 3    zeigt die Querschnittsebenen, die Anlageebenen und die Längsebenen,

Figur 4    in Teilfigur 4a eine Helix zum Erläutern der Verseilungs-Parameter und in Teilfigur 4b eine schematische perspektivische Ansicht eines Kabels mit drei helikal verseilten Leitern und

Figur 5    einen Querschnitt durch ein erfindungsgemäßes Strommessgerät mit einer konkaven Leitstruktur.

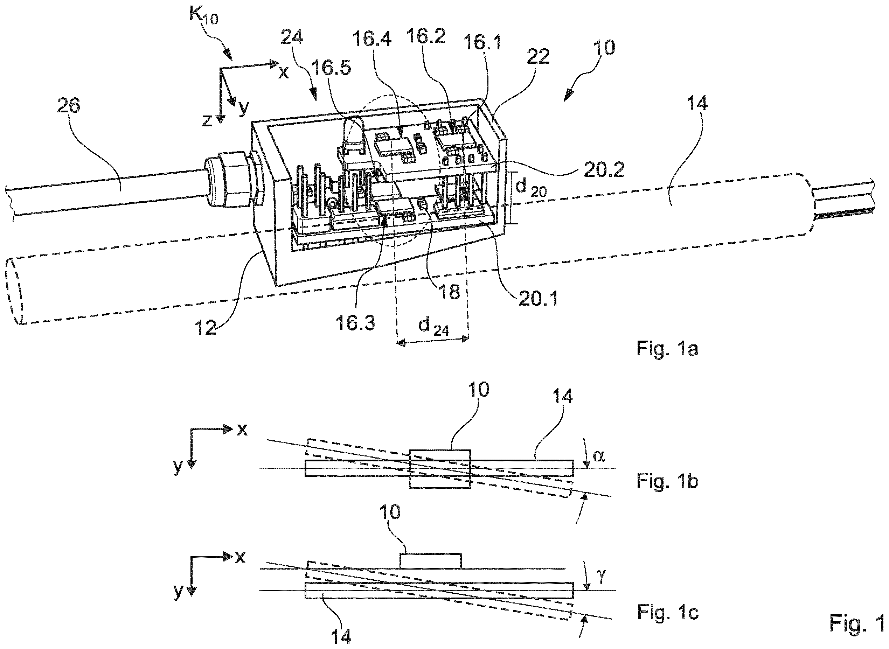

Figur 1a zeigt ein erfindungsgemäßes Strommessgerät 10, das eine Anlagefläche 12 aufweist. Es ist möglich, dass die Anlagefläche 12 plan ausgebildet ist. Es ist aber beispielsweise auch möglich, dass die Anlagefläche 12 konkav ausgebildet ist. Das macht ein Anlegen auf einem Kabel 14 besonders einfach. Das Kabel 14 hat N Leiter 15.n (n = 1, ..., N).

Das Kabel 14 und die Leiter haben eine Leiterlängsachse L. Das Strommessgerät 10 hat eine Erstreckungsrichtung E.

Das Strommessgerät 10 besitzt vektorielle Magnetfeldsensoren 16.m (m = 1, 2, ..., Q). Q ist die Anzahl der Magnetfeldsensoren. Das Strommessgerät 10 umfasst zudem eine Auswerteeinheit 18, die mit den Magnetfeldsensoren 16.m verbunden ist. Die Magnetfeldsensoren 16.m sind im vorliegenden Fall Dünnschicht-Sensoren.

Die Magnetfeldsensoren 16.1, 16.3 und 16.5 sind auf einer gemeinsamen ersten Platine 201. befestigt. Die Magnetfeldsensoren 16.2 und 16.4 sind auf einer gemeinsamen zweiten Platine 20.2 befestigt. Die beiden Platinen 20.1, 20.2 haben einen Platinen-Abstand $d_{20}$, der - unabhängig von anderen Merkmalen des Strommessgeräts - vorzugsweise zwischen $d_{20}$ = 2 mm und $d_{20}$ = 20 mm liegt.

Die Magnetfeldsensoren 16.m besitzen jeweils einen Magnetfeldsensor-Abstand $d_{m1,m2}$ voneinander. So haben die Magnetfeldsensoren 16.4 und 16.1 einen Magnetfeldsensor-Abstand $d_{2,4}$ voneinander. Die Magnetfeldsensor-Abstände $d_{m1,m2}$ liegen vorzugsweise zwischen 2 mm und 100 mm.

Die Platinen 20.1, 20.2 sind starr miteinander verbunden. Im vorliegenden Fall sind beide Platinen 20.1, 20.2 zu diesem Zweck mit einem Gehäuse 22 verbunden. In einem Geräte-Koordinatensystem $K_{10}$ werden die Positionen der Magnetfeldsensoren 16.m angegeben durch den Vektor $\vec{r}_m$. Die x-Achse des Geräte-Koordinatensystems $K_{10}$ verläuft parallel zur Erstreckungsrichtung E.

Die Magnetfeldsensoren 16.m messen jeweils ein Magnetfeld $\vec{B}m = (Bx,m, B_y,m, Bz,m)$, wodurch Magnetfeldkomponentendaten erhalten werden. Der erste Magnetfeldsensor 16.1 erzeugt Magnetfeldkomponenten-Daten, die das Magnetfeld $(B_{x,1}, B_{y,1}, B_{z,1})$ kodieren. Da insgesamt Q Magnetfeldsensoren vorhanden sind, ergibt sich so der Vektor aller Messergebnisse $\vec{m}$.

Figur 1b zeigt die Bestimmung eines Ausrichtungswinkels $\alpha$. Figur 1c zeigt die Bestimmung eines Neigungswinkels y. Diese werden vom Benutzer mittels einer Eingabevorrichtung 28 eingegeben, die ein Datenkabel 26 mit der Auswerteeinheit 18 verbunden ist.

Die Auswerteeinheit 18 erfasst die Magnetfeldkomponenten-Daten von den Magnetfeldsensoren 16.m und erfasst den Ausrichtungswinkel $\alpha$ und den Neigungswinkel y. von der Eingabevorrichtung 28. Alternativ werden Werte für den Ausrichtungswinkel $\alpha$ und den Neigungswinkel y aus einem digitalen Speicher ausgelesen.

Die Auswerteeinheit 18 berechnet dann den Modelldatenvektor $\vec{K}$, der den Ausdruck $\|\vec{m} - \vec{K}\|^2$ minimiert, der als Abweichung A $(=\|\vec{m} - \vec{K}\|^2)$ bezeichnet wird. A wird beispielsweise mittels des Levenberg-Marquardt-Algorithmus minimiert. Aus dem Modelldatenvektor $\vec{K}$, berechnet die Auswerteeinheit 18 dann aus Formel (1) die Stromstärken $I_n$ für alle n. Die Stromstärken werden von einer Ausgabevorrichtung 30, beispielsweise einem Bildschirm, ausgegeben.

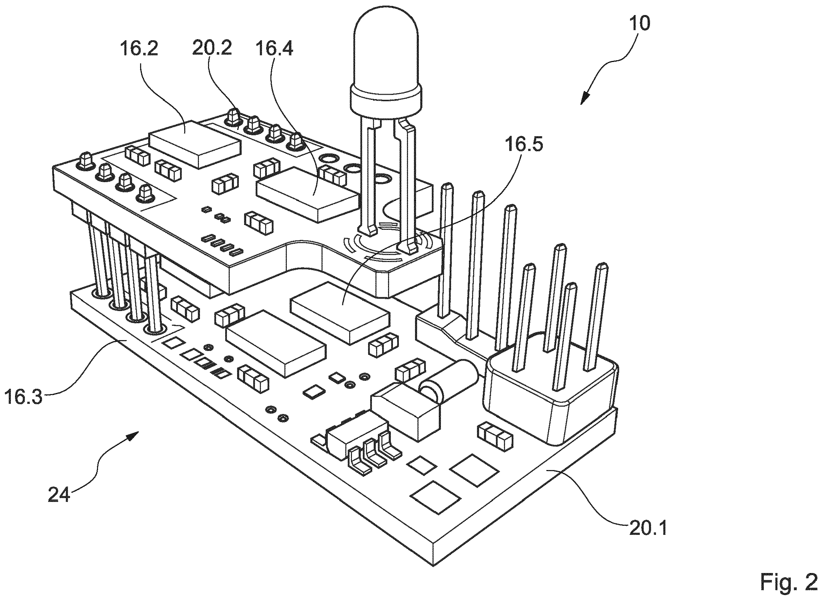

Figur 2 zeigt eine Teilansicht einer Schaltung 24, die die Platinen 20.1, 20.2 aufweist. Über ein Datenkabel 26 können entweder die Messergebnisse der Magnetfeldsensoren ausgelesen werden. Alternativ werden die von der Auswerteeinheit 18 berechneten Ströme übermittelt.

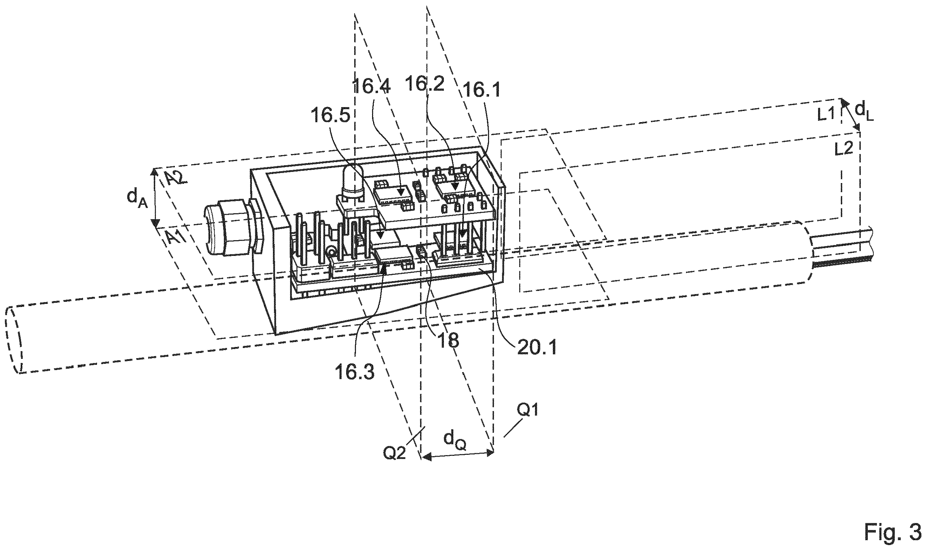

Figur 3 zeigt, dass die Magnetfeldsensoren 16.1, 16.2 in einer ersten Querschnittsebene Q1 liegen. Die Magnetfeldsensoren 16.3, 16.4 und 16.5 liegen in einer zweiten, parallel verlaufenden Querschnittsebene Q2, die einen Querschnittsebenen-Abstand da von im vorliegenden Fall da = 15 mm hat.

Die Magnetfeldsensoren 16.1, 16.4, 16.5 liegen zudem in einer ersten Längsebene L1. Der Magnetfeldsensor 16.3 liegt in einer zweiten, parallel verlaufenden Längsebene L2, die einen Längsebenen-Abstand $d_L$ von in vorliegenden Fall $d_L$ = 6 mm hat.

Die Magnetfeldsensoren 16.1, 16.3, 16.5 liegen zudem in einer Anlageebene A1. Die Magnetfeldsensoren 16.2, 16.4 liegen in einer zweiten, parallel verlaufenden Anlageebene A2, die einen Anlageebenen-Abstand $d_A$ von im vorliegenden Fall $d_A$ = 15 mm hat.

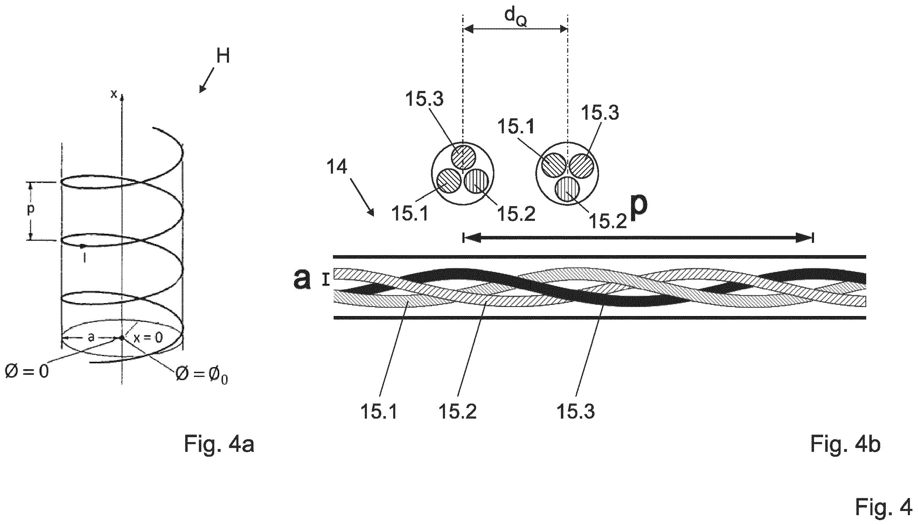

Figur 4a zeigt eine Helix H mit der Ganghöhe p und dem Helixradius a.

Figur 4b zeigt schematisch ein Kabel 14 mit drei Leitern 15.1, 15.2, 15.3. Die oben eingezeichneten Querschnitte zeigen, dass die Querschnitte bis auf eine Drehung gleich sind.

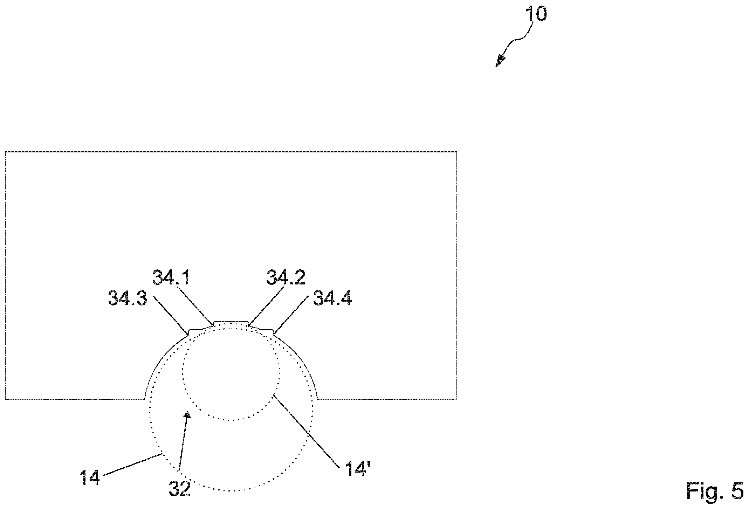

Figur 5 zeigt einen Querschnitt durch ein erfindungsgemäßes Strommessgerät 10 mit einer Leitstruktur 32, die zumindest im Wesentlichen konkav sein kann, nicht aber sein muss. Unter dem Merkmal, dass die Leitstruktur 32 im Wesentlichen konkav ist, wird insbesondere verstanden, dass ein Zylinder existiert, an den sie flächig anliegen kann, wobei die Anlagefläche unterbrochen sein kann.

Eingezeichnet sind schematisch zwei Kabel 14, 14' unterschiedlicher Durchmesser. Es ist zu erkennen, dass das Kabel 14 flächig an der Leitstruktur 32 anliegt. Das Kabel 14' liegt an zwei Anlagekanten 34.1, 34.2 der Leitstruktur 32 an. Günstig ist es, wenn die Leitstruktur 32 zwei weitere Anlagekanten 34.3, 34.4 aufweist, an denen ein weiteres Kabel mit einem unterschiedlichen Durchmesser anliegen kann.

**Bezugszeichenliste**

| | | | | |
|---|---|---|---|---|
| 10 | Strommessgerät | | $d_{20}$ | Platinen-Abstand |
| 12 | Anlagefläche | | $d_{m1,m2}$ | Magnetfeldsensor-Abstand |
| 14 | Kabel | | E | Erstreckungsrichtung |
| 15 | Leiter | | $H_g$ | modifizierte Besselfunktionen |
| 16 | Magnetfeldsensoren | | I | Stromstärke |
| 18 | Auswerteeinheit | | $I_{grenz}$ | Mindest-Stromstärkewert |
| | | | Imin | Minimum-Stromstärke |
| 20 | Platine | | $I_{ok}$ | Kontrollwert |
| 22 | Gehäuse | | $I_n$ | Stromstärke im n-ten Leiter |
| 24 | Schaltung | | $\vec{K}$ | Modelldatenvektor |
| 26 | Datenkabel | | $K_{10}$ | Geräte-Koordinatensystem |

(fortgesetzt)

| | | | |
|---|---|---|---|
| 28 | Eingabevorrichtung | $K_k$ | Komponente des Modelldaten-vektors |
| 30 | Ausgabevorrichtung | | |
| 32 | Leitstruktur | L | Leiterlängsachse |
| | | $\vec{m}$ | Messwertvektor |
| $\alpha$ | Ausrichtungswinkel | m | Laufindex der Magnetfeldsen-soren |
| $\beta_{m,n}$ | Winkel zwischen dem m-ten Magnetometer und dem n-ten Leiter | n | Laufindex der Leiter |
| | | N | Zahl der Leiter |
| $\gamma$ | Neigungswinkel | p | zweiter Verseilungsparameter (Ganghöhe) |
| Ø | Winkelkoordinate in einem Zylinderkoordinatensystem (Ø=$\varphi$) | Q | Anzahl der Magnetfeldsensoren |
| a | erster Verseilungsparameter (Helixradius) | $\vec{r}_k = (x_k, y_k, z_k)$ | Mittelpunkt des Kabels mit |
| A | Abweichung | | |
| A1, A2 | Anlageebene | $\vec{r}_m$ | Position des m-ten Magnetfeld-sensors im Geräte-Koordinatensystem |
| $C_g$ | modifizierten Besselfunktion | | |
| $d_A$ | Anlageebenen-Abstand | Ø | |
| $d_L$ | Längsebenen-Abstand | | |
| da | Querschnittsebenen-Abstand | | |
| $B_{x,m}$ | x-Komponente | | |

## Patentansprüche

1. **Strommessgerät** (10) zum Messen von Stromstärken ($I_n$) in Leitern eines Kabels (14) mit N $\geq$ 2 Leitern (15), mit

   (a) Q vektoriellen Magnetfeldsensoren (16), wobei Q $\geq$ 5 und
   (b) einer Auswerteeinheit (18), die ausgebildet ist zum automatischen

   (i) Erfassen von Magnetfeldkomponenten-Daten von drei Magnetfeldkomponenten ($B_x$, $B_y$, $B_z$) mittels der Magnetfeldsensoren (16) und
   (ii) Berechnen der zumindest einen Stromstärke ($I_n$) aus den Magnetfeldkomponenten-Daten.

   (c) wobei zumindest zwei der Magnetfeldsensoren (16.1, 16.2) in einer ersten Querschnittsebene (Q1) liegen,

   **dadurch gekennzeichnet, dass**

   (d) zumindest zwei weitere Magnetfeldsensoren (16.3, 16.4, 16.5) in einer zweiten Querschnittsebene (Q2) liegen, die parallel zur ersten Querschnittsebene (Q1) verläuft,
   (e) zumindest zwei der Magnetfeldsensoren (16.1, 16.3, 16.5) in einer ersten Anlageebene (A1) liegen, wobei die erste Anlageebene (A1) senkrecht zur Querschnittsebene (Q1) verläuft,
   (f) zumindest zwei weitere Magnetfeldsensoren (16.2, 16.4) in einer zweiten Anlageebene (A2) liegen, die parallel zur ersten Anlageebene (A1) verläuft,
   (g) zumindest zwei der Magnetfeldsensoren (16.2, 16.4, 16.5) in einer ersten Längsebene (L1) liegen, wobei die erste Längsebene (L1) senkrecht zur Querschnittsebene (Q1) und senkrecht zur Anlageebene (A1) verläuft, und
   (h) zumindest ein weiterer Magnetfeldsensor (16.3) in einer zweiten Längsebene (L2) liegt, die parallel zur ersten Längsebene (L1) verläuft.

2. Strommessgerät (10) nach Anspruch 1, **dadurch gekennzeichnet, dass**

   (a) ein Querschnittsebenen-Abstand (da) der Querschnittsebenen (Q1, Q2) zumindest 10 mm beträgt und/*oder*
   (b) ein Anlageebenen-Abstand ($d_A$) der Anlageebenen (A1, A2) zumindest 2 mm beträgt und/oder
   (c) ein Längsebenen-Abstand ($d_L$) der Längsebenen (L1, L2) zumindest 4 mm beträgt und/oder

(d) die Magnetfeldsensoren (16) jeweils einen Magnetfeldsensor-Abstand ($d_{m1,m2}$) voneinander haben, der zumindest 2 Millimeter und/oder höchstens 100 Millimeter beträgt.

3. Strommessgerät (10) nach einem der vorstehenden Ansprüche, **dadurch gekennzeichnet, dass**

(a) die Magnetfeldsensoren (16) Dünnschicht-Sensoren sind, die unter Einfluss eines magnetischen Flusses ihren elektrischen Widerstand ändern
(b) zumindest zwei der Dünnschicht-Sensoren auf einer gemeinsamen Platine (20) und/oder auf einem gemeinsamen Chip angeordnet sind und/oder
(c) zumindest zwei der Dünnschicht-Sensoren

- auf zwei unterschiedlichen Platinen (20), die miteinander starr, insbesondere stoffschlüssig, verbunden sind, und/oder
- auf zwei unterschiedlichen Chips, die miteinander starr, insbesondere stoffschlüssig, verbunden sind,

angeordnet sind.

4. Strommessgerät (10) nach einem der vorstehenden Ansprüche, **dadurch gekennzeichnet, dass**

die Auswerteeinheit (18) ausgebildet ist zum automatischen Berechnen der Stromstärken ($I_n$) und zumindest eines Verseilungs-Parameter (a, p) in Form

- eines Ganghöhen-Parameters (p) und/oder
- eines Helixradius-Parameters (a)

aus den Magnetfeldkomponenten-Daten,
wobei für die Stromstärken ($I_n$) und den zumindest einen Verseilungs-Parameter (a, p) gilt, dass eine Abweichung (A) zwischen

- den Magnetfeldkomponenten-Daten ($\vec{m}$) und
- Magnetfeldkomponenten-Werten, die berechnet sind unter Annahme gleicher Querschnitte des Kabels bezüglich der ersten Querschnittsebene und der zweiten Querschnittsebene und
für alle Leiter des Kabels jeweils gleicher Stromstärken durch die erste Querschnittsebene und die zweite Querschnittsebene,

minimiert ist.

5. Strommessgerät (10) nach einem der vorstehenden Ansprüche, **dadurch gekennzeichnet, dass** die Auswerteeinheit (18) ausgebildet ist zum automatischen Durchführen eines Verfahrens mit den Schritten:

(i) unter der Annahme unverseilter Leiter Berechnen von Stromstärke-Schätzwerten der Stromstärken ($I_n$) und von Positions-Schätzwerten der Positionen ($\vec{r_n}$) der Leiter,
(ii) iterativ Verändern des zumindest einen Verseilungs-Parameter (a, p) und der Stromstärke-Schätzwerte, sodass die Abweichung (A) minimiert wird.

6. Strommessgerät (10) nach einem der vorstehenden Ansprüche, **dadurch gekennzeichnet, dass**

die Auswerteeinheit (18) ausgebildet ist zum automatischen Berechnen

- der Stromstärken ($I_n$),
- zumindest eines Verseilungs-Parameter (a, p) und
- zumindest einen Positionierungsparameters ($\alpha,\gamma$) in Form

eines Ausrichtungswinkels ($\alpha$) zwischen einer Erstreckungsrichtung (E) des Strommessgeräts (10) und einer Leiterlängsachse (L) des Leiters (15) und/oder
eines Neigungswinkels (y) zwischen einer Anlagefläche des Strommessgeräts und einer Leiterlängsachse (L)

aus den Magnetfeldkomponenten-Daten,
wobei für die Stromstärken ($I_n$), den Ganghöhen-Parameter (p) und den zumindest einen Positionierungsparameter ($\alpha,\gamma$) gilt, dass eine Abweichung (A) zwischen

- den Magnetfeldkomponenten-Daten einerseits und
- Magnetfeldkomponenten-Werten, die berechnet sind unter Annahme gleicher Querschnitte des Kabels bezüglich der ersten Querschnittsebene und der zweiten Querschnittsebene und
für alle Leiter des Kabels jeweils gleicher Stromstärken durch die erste Querschnittsebene und die zweite Querschnittsebene,

minimiert ist,

7. Strommessgerät (10) nach einem der vorstehenden Ansprüche, **dadurch gekennzeichnet, dass** die Auswerteeinheit (18) ausgebildet ist zum automatischen Durchführen eines Verfahrens mit den Schritten

    (i) Erfassen der Anzahl N an Leitern (15), insbesondere von einer Eingabevorrichtung (28), und
    (ii) Berechnen der Stromstärken ($I_n$) für N Leiter (15).

8. Strommessgerät (10) nach Anspruch 7, **dadurch gekennzeichnet, dass** die Auswerteeinheit (18) ausgebildet ist zum automatischen Durchführen eines Verfahrens mit den Schritten:

    (i) Berechnen der Stromstärken ($I_n$) für N Leiter (15) und für (N+1) Leiter (15), sodass Mehrleiter-Stromstärken ($I_n$, $I_{n+1}$) erhalten werden,
    (ii) Bestimmen einer Minimum-Stromstärke ($I_{min}$) in Form der kleinsten der (N+1) Mehrleiter-Stromstärken ($I_{n+1}$) und
    (iii) Ausgeben der Stromstärken für N Leiter (15), wenn die Minimum-Stromstärke ($I_{min}$) für (N+1) Leiter kleiner ist als ein vorgegebener Mindest-Stromstärkewert ($I_{grenz}$).

9. Strommessgerät (10) nach einem der Ansprüche 7 oder 8, **dadurch gekennzeichnet, dass** die Auswerteeinheit (18) ausgebildet ist zum automatischen Durchführen eines Verfahrens mit den Schritten:

    (a) Bestimmen einer Minimum-Stromstärke in Form einer kleinsten Stromstärke($I_{min}$),
    (b) wenn die Minimum-Stromstärke ($I_{min}$) kleiner ist als ein vorgegebener Mindest-Strom stärkewert,

        (i) Bestimmen einer Minimum-Stromstärke ($I_{min}$) in Form einer kleinsten Stromstärke für (N-1) Leiter (15),
        (ii) wenn die Minimum-Stromstärke ($I_{min}$) für (N-1) Leiter (15) kleiner ist als der vorgegebene Mindest-Stromstärkewert ($I_{grenz}$), Wiederholen von Schritt (i) für jeweils einen Leiter (15) weniger, bis die Minimum-Stromstärke ($I_{min}$) zumindest dem Mindest-Stromstärkewert ($I_{grenz}$) entspricht, und
        (iii) Ausgeben einer Meldung, die die Zahl der Leiter (15) kodiert, für die gilt, dass die Minimum-Stromstärke ($I_{min}$) zumindest dem Mindest-Stromstärkewert (Igrenz) entspricht.

10. Strommessgerät (10) nach einem der vorstehenden Ansprüche, **gekennzeichnet durch** eine Anlagefläche (12), die eine Leitstruktur (32) aufweist, die sich entlang einer Koordinatenachse eines Geräte-Koordinatensystems ($K_{10}$) erstreckt.

11. Verfahren zum Bestimmen zumindest einer Stromstärke in zumindest einem Leiter (15), mit den Schritten:

    (a) Positionieren eines Strommessgeräts (10) nach einem der vorstehenden Ansprüche relativ zu N Leitern (15),
    (b) Erfassen von Magnetfeldkomponenten-Daten von zumindest jeweils zwei Magnetfeldkomponenten ($B_y$, $B_z$) mittels der Magnetfeldsensoren (16) und
    (c) automatisches Berechnen der zumindest einen Stromstärke ($I_n$) aus den Magnetfeldkomponenten-Daten.

12. Verfahren nach Anspruch 11 **dadurch gekennzeichnet, dass** die Leiter, insbesondere helikal, verseilt sind.

13. Verfahren Anspruch 11 oder 12, **gekennzeichnet durch** die Schritte:

    (iii) Erfassen der Anzahl N an Leitern (15), insbesondere von einer Eingabevorrichtung (28), und
    (iv) Berechnen der Stromstärken ($I_n$) für N Leiter (15).

**14.** Verfahren nach Anspruch 13, **gekennzeichnet durch** die Schritte:

(iv) Berechnen der Stromstärken ($I_n$) für N Leiter (15) und für (N+1) Leiter (15), sodass Mehrleiter-Stromstärken ($I_n$, $I_{n+1}$) erhalten werden,
(v) Bestimmen einer Minimum-Stromstärke ($I_{min}$) in Form der kleinsten der (N+1) Mehrleiter-Stromstärken ($I_{n+1}$) und
(vi) Ausgeben der Stromstärken für N Leiter (15), wenn die Minimum-Stromstärke ($I_{min}$) für (N+1) Leiter kleiner ist als ein vorgegebener Mindest-Stromstärkewert ($I_{grenz}$).

**15.** Verfahren nach Anspruch 13 oder 14, **gekennzeichnet durch** die Schritte:

(c) Bestimmen einer Minimum-Stromstärke in Form einer kleinsten Stromstärke($I_{min}$),
(d) wenn die Minimum-Stromstärke ($I_{min}$) kleiner ist als ein vorgegebener Mindest-Strom stärkewert,

(iv) Bestimmen einer Minimum-Stromstärke ($I_{min}$) in Form einer kleinsten Stromstärke für (N-1) Leiter (15),
(v) wenn die Minimum-Stromstärke ($I_{min}$) für (N-1) Leiter (15) kleiner ist als der vorgegebene Mindest-Stromstärkewert ($I_{grenz}$), Wiederholen von Schritt (i) für jeweils einen Leiter (15) weniger, bis die Minimum-Stromstärke ($I_{min}$) zumindest dem Mindest-Stromstärkewert ($I_{grenz}$) entspricht, und
(vi) Ausgeben einer Meldung, die die Zahl der Leiter (15) kodiert, für die gilt, dass die Minimum-Stromstärke ($I_{min}$) zumindest dem Mindest-Stromstärkewert (Igrenz) entspricht.

**Claims**

**1.** A current measurement device (10) for measuring currents ($I_n$) in conductors of a cable (14) with N $\geq$ 2 conductors (15), comprising

(a) Q vectorial magnetic field sensors (16), wherein Q $\geq$ 5 and
(b) an evaluation unit (18) that is designed to automatically

(i) detect magnetic field component data from three magnetic field components ($B_x$, $B_y$, $B_z$) by means of the magnetic field sensors (16) and
(ii) calculate the at least one current ($I_n$) from the magnetic field component data,

(c) wherein at least two of the magnetic field sensors (16.1, 16.2) are located in a first cross-sectional plane (Q1),

**characterised in that**

(d) at least two further magnetic field sensors (16.3, 16.4, 16.5) are located in a second cross-sectional plane (Q2), which extends parallel to the first cross-sectional plane (Q1),
(e) at least two of the magnetic field sensors (16.1, 16.3, 16.5) are located in a first contact plane (A1), the first contact plane (A1) extending perpendicular to the first cross-sectional plane (Q1),
(f) at least two further magnetic field sensors (16.2, 16.4) are located in a second contact plane (A2), which extends parallel to the first contact plane (A1),
(g) at least two of the magnetic field sensors (16.2, 16.4, 16.5) are located in a first longitudinal plane (L1), the first longitudinal plane (L1) extending perpendicular to the first cross-sectional plane (Q1) and perpendicular to the contact plane (A1), and
(h) at least one further magnetic field sensor (16.3) is located in a second longitudinal plane (L2), which extends parallel to the first longitudinal plane (L1).

**2.** The current measurement device (10) according to claim 1, **characterised in that**

(a) a cross-section plane distance (da) of the cross-sectional planes (Q1, Q2) is at least 10 mm and/or
(b) a contact plane distance ($d_A$) of the contact planes (A1, A2) is at least 2 mm and/or
(c) a longitudinal plane distance ($d_A$) of the longitudinal planes (L1, L2) is at least 4 mm and/or
(d) the magnetic field sensors (16) are each at a magnetic field sensor distance ($d_{m1,m2}$) from each other that is at least 2 millimetres and/or at most 100 millimetres.

**3.** The current measurement device (10) according to one of the preceding claims, **characterised in that**

(a) the magnetic field sensors (16) are thin-film sensors that change their electrical resistance under the influence of a magnetic flux,
(b) at least two of the thin-film sensors are arranged on a joint board (20) and/or on a joint chip and/or
(c) at least two of the thin-film sensors are arranged

- on two different boards (20), which are rigidly connected to each other, in particular by way of a material bond, and/or
- on two different chips, which are rigidly connected to each other, in particular by way of a material bond.

**4.** The current measurement device (10) according to one of the preceding claims, **characterised in that**

the evaluation unit (18) is designed to automatically calculate the currents ($I_n$) and at least one stranding parameter (a, p) in the form of

- a pitch parameter (p) and/or
- a helix radius parameter (a)

from the magnetic field component data,
it being the case for the currents ($I_n$) and the at least one stranding parameter (a, p) that a deviation (A) between

- the magnetic field component data ($\vec{m}$) and
- magnetic field component values, which are calculated on the assumption of

equal cross-sections of the cable in terms of the first cross-sectional plane and the second cross-sectional plane, and
equal currents through the first cross-section and the second cross-section for each conductor of the cable,

is minimised.

**5.** The current measurement device (10) according to one of the preceding claims, **characterised in that** the evaluation unit (18) is configured to automatically execute a method containing the steps:

(i) assuming unstranded conductors, calculating current estimates of the currents ($I_n$) and position estimates of the positions ($\vec{r_n}$) of the conductors,
(ii) iteratively changing the at least one stranding parameter (a, p) and the current estimates so that the deviation (A) is minimised.

**6.** The current measurement device (10) according to one of the preceding claims, **characterised in that**

the evaluation unit (18) is designed to automatically calculate

- the currents ($I_n$),
- at least one stranding parameter (a, p) and
- at least one positioning parameter ($\alpha,\gamma$) in the form of

an angle of orientation ($\alpha$) between an angle of extension (E) of the current measurement device (10) and a conductor longitudinal axis of the conductor (15) and/or
an angle of inclination (y) between a contact surface of the current measurement device and a conductor longitudinal axis (L)

from the magnetic field component data,
it being the case for the currents ($I_n$), the pitch parameter (p) and the at least one positioning parameter ($\alpha,\gamma$) that a deviation (A) between

- the magnetic field component data on the one hand and
- magnetic field component values, which are calculated on the assumption of

equal cross-sections of the cable in terms of the first cross-sectional plane and the second cross-sectional plane, and
equal currents through the first cross-section and the second cross-section for all conductors of the cable,

is minimised.

7. The current measurement device (10) according to one of the preceding claims, **characterised in that** the evaluation unit (18) is configured to automatically execute a method containing the steps:

(i) detecting the number N of conductors (15), in particular from an input device (28), and
(ii) calculating the currents ($I_n$) for N conductors (15).

8. The current evaluation device (10) according to claim 7, **characterised in that** the evaluation unit (18) is designed to automatically execute a method containing the steps:

(i) calculating the currents ($I_n$) for N conductors (15) and for (N+1) conductors (15), so that multi-conductor currents ($I_n$, $I_{n+1}$) are obtained,
(ii) determining a minimum current ($I_{min}$) in the form of the smallest of the (N+1) multi-conductor currents ($I_{n+1}$) and
(iii) outputting the currents for N conductors (15) when the minimum current ($I_{min}$) for (N+1) conductor is smaller than a predetermined minimum current value ($I_{grenz}$).

9. The current measurement device (10) according to one of the claims 7 or 8, **characterised in that** the evaluation unit (18) is configured to automatically execute a method containing the steps:

(a) determining a minimum current in the form of a smallest currents ($I_{min}$)
(b) when the minimum current ($I_{min}$) is smaller than a predetermined minimum current value,

(i) determining a minimum current ($I_{min}$) in the form of a smallest current for (N-1) conductors (15)
(ii) when the minimum current ($I_{min}$) for (N-1) conductors (15) is smaller than the predetermined minimum current value ($I_{grenz}$),
repeating step (i) for one conductor (15) less at a time until the minimum current ($I_{min}$) is at least equal to the minimum current value ($I_{grenz}$), and
(iii) outputting a notification that encodes the number of the conductors (15), for which the following applies: the minimum current ($I_{min}$) is at least equal to the minimum current value ($I_{grenz}$).

10. The current measurement device (10) according to one of the preceding claims, **characterised in that** a contact surface (12) with a guide structure (32) which extends along a coordinate axis of a device coordinate system ($K_{10}$).

11. A method for determining at least one current in at least one conductor (15) featuring the steps:

(a) positioning a current measurement device (10) according to one of the preceding claims relative to N conductors (15),
(b) detecting magnetic field component data from at least two magnetic field components ($B_y$, $B_z$) by means of the magnetic field sensors (16) and
(c) automatically calculating the at least one current ($I_n$) from the magnetic field component data.

12. The method according to claim 11, **characterised in that**
the conductors are stranded, especially helically.

13. The method according to claim 11 or 12, **characterised by** the steps:

(iii) detecting the number N of conductors (15), in particular from an input device (28), and
(iv) calculating the currents ($I_n$) for N conductors (15).

**14.** The method according to claim 13, **characterised by** the steps:

(iv) calculating the currents ($I_n$) for N conductors (15) and for (N+1) conductors (15), so that multi-conductor currents ($I_n$, $I_{n+1}$) are obtained,
(v) determining a minimum current ($I_{min}$) in the form of the smallest of the (N+1) multi-conductor currents ($I_{n+1}$) and
(vi) outputting the currents for N conductors (15) when the minimum current ($I_{min}$) for (N+1) conductor is smaller than a predetermined minimum current value ($I_{grenz}$).

**15.** The method according to claim 13 or 14, **characterized by** the steps:

(c) determining a minimum current in the form of a smallest currents ($I_{min}$)
(d) when the minimum current ($I_{min}$) is smaller than a predetermined minimum current value,

(iv) determining a minimum current ($I_{min}$) in the form of a smallest current for (N-1) conductors (15)
(v) when the minimum current ($I_{min}$) for (N-1) conductors is smaller than the predetermined minimum current value ($I_{grenz}$),
repeating step (i) for one conductor (15) less at a time until the minimum current ($I_{min}$) is at least equal to the minimum current value ($I_{grenz}$), and
(vi) outputting a notification that encodes the number of the conductors (15), for which the following applies: the minimum current ($I_{min}$) is at least equal to the minimum current value ($I_{grenz}$).

## Revendications

**1.** Appareil de mesure de courant (10) pour mesurer des intensités de courant ($I_n$) dans des conducteurs d'un câble (14) ayant N $\geq$ 2 conducteurs (15), comprenant

(a) Q capteurs de champ magnétique vectoriels (16), où Q $\geq$ 5, et
(b) une unité d'évaluation (18) réalisée pour automatiquement

(i) acquérir des données de composantes de champ magnétique de trois composantes de champ magnétique ($B_x$, $B_y$, $B_z$) au moyen des capteurs de champ magnétique (16), et
(ii) calculer ladite au moins une intensité de courant ($I_n$) à partir des données de composantes de champ magnétique,

(c) au moins deux desdits capteurs de champ magnétique (16.1, 16.2) étant situés dans un premier plan de section transversale (Q1),

**caractérisé en ce que**

(d) au moins deux autres capteurs de champ magnétique (16.3, 16.4, 16.5) sont situés dans un deuxième plan de section transversale (Q2) qui est parallèle au premier plan de section transversale (Q1),
(e) au moins deux desdits capteurs de champ magnétique (16.1, 16.3, 16.5) sont situés dans un premier plan d'application (A1), le premier plan d'application (A1) étant perpendiculaire au plan de section transversale (Q1),
(f) au moins deux autres capteurs de champ magnétique (16.2, 16.4) sont situés dans un deuxième plan d'application (A2) qui est parallèle au premier plan d'application (A1),
(g) au moins deux desdits capteurs de champ magnétique (16.2, 16.4, 16.5) sont situés dans un premier plan longitudinal (L1), le premier plan longitudinal (L1) étant perpendiculaire au plan de section transversale (Q1) et perpendiculaire au plan d'application (A1), et
(h) au moins un autre capteur de champ magnétique (16.3) est situé dans un deuxième plan longitudinal (L2) qui est parallèle au premier plan longitudinal (L1).

**2.** Appareil de mesure de courant (10) selon la revendication 1, **caractérisé en ce que**

(a) une distance de plan de section transversale ($d_Q$) des plans de section transversale (Q1, Q2) est d'au moins 10 mm, et/ou
(b) une distance de plan d'application ($d_A$) des plans d'application (A1, A2) est d'au moins 2 mm, et/ou
(c) une distance de plan longitudinal ($d_L$) des plans longitudinaux (L1, L2) est d'au moins 4 mm, et/ou

(d) les capteurs de champ magnétique (16) ont une distance de capteur de champ magnétique ($d_{m1,m2}$) respective entre eux qui est de 2 millimètres au minimum et/ou de 100 millimètres au maximum.

3. Appareil de mesure de courant (10) selon l'une des revendications précédentes, **caractérisé en ce que**

(a) les capteurs de champ magnétique (16) sont des capteurs à couche mince qui changent de résistance électrique sous l'influence d'un flux magnétique,
(b) au moins deux desdits capteurs à couche mince sont disposés sur une platine commune (20) et/ou sur une puce commune, et/ou
(c) au moins deux desdits capteurs à couche mince sont disposés

- sur deux platines (20) différentes, qui sont reliées entre elles de manière rigide, en particulier par coopération de matière, et/ou
- sur deux puces différentes qui sont reliées entre elles de manière rigide, en particulier par coopération de matière.

4. Appareil de mesure de courant (10) selon l'une des revendications précédentes, **caractérisé en ce que**

l'unité d'évaluation (18) est réalisée pour calculer automatiquement les intensités de courant ($I_n$) et au moins un paramètre de toronnage (a, p) sous la forme

- d'un paramètre de hauteur de pas (p) et/ou
- d'un paramètre de rayon d'hélice (a)

à partir des données de composantes de champ magnétique,
où, pour les intensités de courant ($I_n$) et ledit au moins un paramètre de toronnage (a, p), il est entendu qu'un écart (A) entre

- les données de composantes de champ magnétique ($\vec{m}$) et
- des valeurs de composantes de champ magnétique, calculées en supposant

des sections transversales identiques du câble par rapport au premier plan de section transversale et au deuxième plan de section transversale et
pour tous les conducteurs du câble, des intensités de courant identiques à travers le premier plan de section transversale et le deuxième plan de section transversale

est minimisé.

5. Appareil de mesure de courant (10) selon l'une des revendications précédentes, **caractérisé en ce que** l'unité d'évaluation (18) est réalisée pour mettre en œuvre automatiquement un procédé comprenant les étapes consistant à :

(i) calculer des estimations d'intensité de courant des intensités de courant ($I_n$) et calculer des estimations de position des positions ($\vec{r_n}$) des conducteurs, en supposant des conducteurs non toronnés,
(ii) modifier de manière itérative ledit au moins un paramètre de toronnage (a, p) et lesdites estimations d'intensité de courant, de manière à minimiser l'écart (A).

6. Appareil de mesure de courant (10) selon l'une des revendications précédentes, **caractérisé en ce que** l'unité d'évaluation (18) est réalisée pour calculer automatiquement

- les intensités de courant ($I_n$),
- au moins un paramètre de toronnage (a, p) et
- au moins un paramètre de positionnement (a, y) sous la forme d'un angle d'orientation ($\alpha$) entre une direction d'extension (E) de l'appareil de mesure de courant (10) et un axe longitudinal (L) du conducteur (15), et/ou un angle d'inclinaison ($\gamma$) entre une surface d'application de l'appareil de mesure de courant et un axe longitudinal (L) du conducteur
à partir des données de composantes de champ magnétique,

étant entendu que pour les intensités de courant ($I_n$), le paramètre de hauteur de pas (p) et ledit au moins un paramètre de positionnement ($\alpha$, y), un écart (A) entre

- les données de composantes de champ magnétique d'une part et
- des valeurs de composantes de champ magnétique d'autre part, calculées en supposant

des sections transversales identiques du câble par rapport au premier plan de section transversale et au deuxième plan de section transversale et
pour tous les conducteurs du câble, des intensités de courant identiques à travers le premier plan de section transversale et le deuxième plan de section transversale

est minimisé.

7. Appareil de mesure de courant (10) selon l'une des revendications précédentes, **caractérisé en ce que** l'unité d'évaluation (18) est réalisée pour mettre en œuvre automatiquement un procédé comprenant les étapes consistant à

(i) détecter le nombre N de conducteurs (15), en particulier à partir d'un dispositif d'entrée (28), et
(ii) calculer les intensités de courant ($I_n$) pour N conducteurs (15).

8. Appareil de mesure de courant (10) selon la revendication 7, **caractérisé en ce que** l'unité d'évaluation (18) est réalisée pour mettre en œuvre automatiquement un procédé comprenant les étapes consistant à :

(i) calculer les intensités de courant ($I_n$) pour N conducteurs (15) et pour (N+1) conducteurs (15), de sorte à obtenir des intensités de courant multiconducteurs ($I_n$, $I_{n+1}$),
(ii) déterminer une intensité de courant minimum ($I_{min}$) sous la forme de la plus petite des (N+1) intensités de courant multiconducteur ($I_{n+1}$), et
(iii) émettre les intensités de courant pour N conducteurs (15), si l'intensité de courant minimum ($I_{min}$) pour (N+1) conducteurs est inférieure à une valeur d'intensité de courant minimale prédéfinie ($I_{limite}$).

9. Appareil de mesure de courant (10) selon l'une des revendications 7 ou 8, **caractérisé en ce que** l'unité d'évaluation (18) est réalisée pour mettre en œuvre automatiquement un procédé comprenant les étapes consistant à :

(a) déterminer une intensité de courant minimum sous la forme d'une intensité de courant ($I_{min}$) la plus petite,
(b) si l'intensité de courant minimum ($I_{min}$) est inférieure à une valeur d'intensité de courant minimale prédéfinie,

(i) déterminer une intensité de courant minimum ($I_{min}$) sous la forme d'une intensité de courant la plus petite pour (N-1) conducteurs (15),
(ii) si l'intensité de courant minimum ($I_{min}$) pour (N-1) conducteurs (15) est inférieure à la valeur d'intensité de courant minimale prédéfinie ($I_{limite}$),
répéter l'étape (i) pour un conducteur respectif (15) de moins, jusqu'à ce que l'intensité de courant minimum ($I_{min}$) soit au moins égale à la valeur d'intensité minimale ($I_{limite}$), et
(iii) émettre un message codant le nombre de conducteurs (15) pour lesquels l'intensité de courant minimum ($I_{min}$) est au moins égale à la valeur d'intensité de courant minimale ($I_{limite}$).

10. Appareil de mesure de courant (10) selon l'une des revendications précédentes, **caractérisé par** une surface d'application (12) qui comprend une structure conductrice (32) s'étendant le long d'un axe de coordonnées d'un système de coordonnées de l'appareil ($K_{10}$).

11. Procédé de détermination d'au moins une intensité de courant dans au moins un conducteur (15), comprenant les étapes consistant à :

(a) positionner un appareil de mesure de courant (10) selon l'une des revendications précédentes par rapport à N conducteurs (15),
(b) acquérir des données de composantes de champ magnétique d'au moins deux composantes de champ magnétique respectives ($B_y$, $B_z$) au moyen des capteurs de champ magnétique (16), et
(c) calculer automatiquement ladite au moins une intensité de courant ($I_n$) à partir des données de composantes de champ magnétique.

**12.** Procédé selon la revendication 11, **caractérisé en ce que** les conducteurs sont toronnés, en particulier hélicoïdalement.

**13.** Procédé selon la revendication 11 ou 12, **caractérisé par** les étapes consistant à :

(iv) détecter le nombre N de conducteurs (15), en particulier à partir d'un dispositif d'entrée (28), et
(v) calculer les intensités de courant ($I_n$) pour N conducteurs (15).

**14.** Procédé selon la revendication 13, **caractérisé par** les étapes consistant à :

(iv) calculer les intensités de courant ($I_n$) pour N conducteurs (15) et pour (N+1) conducteurs (15), de manière à obtenir des intensités de courant multiconducteurs ($I_n$, $I_{n+1}$),
(v) déterminer une intensité de courant minimum ($I_{min}$) sous la forme de la plus petite des (N+1) intensités de courant multiconducteur ($I_{n+1}$), et
(vi) émettre les intensités de courant pour N conducteurs (15) si l'intensité de courant minimum ($I_{min}$) pour (N+1) conducteurs est inférieure à une valeur d'intensité de courant minimale prédéfinie ($I_{limite}$).

**15.** Procédé selon la revendication 13 ou 14, **caractérisé par** les étapes consistant à :

(c) déterminer une intensité de courant minimum sous la forme d'une intensité de courant la plus petite ($I_{min}$),
(d) si l'intensité de courant minimum ($I_{min}$) est inférieure à une valeur d'intensité de courant minimale prédéfinie,

(iv) déterminer une intensité de courant minimum ($I_{min}$) sous la forme d'une intensité de courant la plus petite pour (N-1) conducteurs (15),
(v) si l'intensité de courant minimum ($I_{min}$) pour (N-1) conducteurs (15) est inférieure à la valeur d'intensité minimale prédéfinie ($I_{limite}$),
répéter l'étape (i) pour un conducteur respectif (15) de moins, jusqu'à ce que l'intensité de courant minimum ($I_{min}$) soit au moins égale à la valeur d'intensité de courant minimale ($I_{limite}$), et
(vi) émettre un message codant le nombre de conducteurs (15) pour lesquels l'intensité de courant minimum ($I_{min}$) est au moins égale à la valeur d'intensité de courant minimale ($I_{limite}$).

EP 3 910 347 B1

Fig. 1a

Fig. 1b

Fig. 1c

Fig. 1

Fig. 2

Fig. 3

Fig. 4b

Fig. 4

Fig. 4a

Fig. 5

10

34.4
34.2
34.1
34.3
14'
32
14

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2018209436 A1
- US 20180088159 A1
- US 20140343878 A1
- EP 1830407 B1
- US 2014097826 A1

**In der Beschreibung aufgeführte Nicht-Patentliteratur**

- **VON SUN et al.** Overhead High-Voltage Transmission-Line Current Monitoring by Magnetoresistive Sensors and Current Source Reconstruction at Transmission Tower. *IEEE Transactions on Magnetics,* Januar 2014, vol. 50 (1